# EUROPEAN PATENT SPECIFICATION

(11) **EP 2 390 386 B1**
(45) Date of publication and mention of the grant of the patent: **12.08.2015**
(21) Application number: 10731243.1
(22) Date of filing: 13.01.2010
(51) Int. Cl.: C30B 29/38, C30B 23/00, C30B 29/40

(54) **METHOD AND APPARATUS FOR PRODUCING NITRIDE SEMICONDUCTOR CRYSTAL**
VERFAHREN UND VORRICHTUNG ZUR HERSTELLUNG EINES NITRIDHALBLEITERKRISTALLS
PROCÉDÉ ET APPAREIL DE PRODUCTION DE CRISTAL SEMI-CONDUCTEUR AU NITRURE

(30) Priority: 16.01.2009 JP 2009007394; 25.12.2009 JP 2009293994
(43) Date of publication of application: 30.11.2011
(73) Proprietor: Sumitomo Electric Industries, Ltd., Chuo-ku Osaka-shi Osaka 541-0041 (JP)
(72) Inventor: SATOH, Issei, Itami-shi Hyogo 664-0016 (JP); MIYANAGA, Michimasa, Osaka-shi Osaka 554-0024 (JP); YAMAMOTO, Yoshiyuki, Itami-shi Hyogo 664-0016 (JP)
(74) Representative: Grünecker Patent- und Rechtsanwälte PartG mbB
(86) International application number: PCT/JP2010/050257
(87) International publication number: WO 2010/082574

(56) References cited:
- JP-A- 2007 145 679
- JP-A- 2008 024 580
- JP-T- 2006 511 432
- JP-T- 2007 500 664
- US-A1- 2003 127 044
- US-A1- 2006 005 763
- US-A1- 2007 256 630
- D. CAI ET AL.: 'Effect of thermal environment evolution on AlN bulk sublimation crystal growth' JOURNAL OF CRYSTAL GROWTH vol. 306, 2007, pages 39 - 46, XP022158362

## Description

### Technical Field

The present invention relates to methods of manufacturing nitride semiconductor crystal, to nitride semiconductor crystals, and to apparatuses for manufacturing nitride semiconductor crystal.

### Background Art

Aluminum nitride (AlN) crystal has a wide energy bandgap of 6.2 eV and a high thermal conductivity of approximately 3.3 WK⁻¹cm⁻¹, and has high electrical resistance as well. AlN crystal and other nitride semiconductor crystals have therefore drawn attention as substrate materials for semiconductor devices such as optoelectronic devices and microelectronic devices. For the method whereby such nitride semiconductor crystal is grown, sublimation growth, for example, is employed (e.g., Non-Patent Reference 1, Patent Reference 1).

Non-Patent Reference 1 sets forth implementing the following steps. At first an AlN crystal source material is emplaced into a crucible made of carbon. Next, the carbonous crucible is heated to a temperature at which the source material sublimes. By subliming the source material the heating generates sublimation gases, enabling the growth of minute AlN crystal at a powdered or particulate level.

Non-Patent Reference 2 teaches the effect of thermal enviironment evolution on AlN bulk sublimation crystal growth.

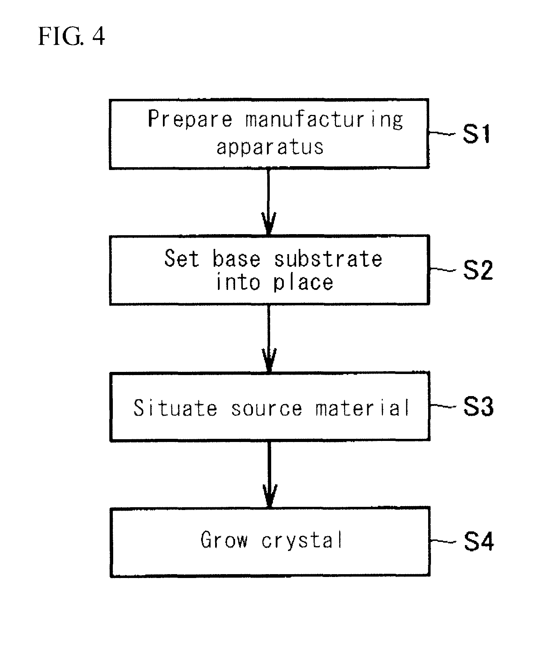

Meanwhile, Patent Reference 1 sets forth manufacturing nitride single crystal by means of the following manufacturing apparatus (e.g., Fig. 4). Namely, the manufacturing apparatus is furnished with an induction heating coil that is a heating means, a heating reactor body disposed to the inside of the induction heating coil, and a crucible, disposed in the lower part of the interior of the heating reactor body, that holds nitride single-crystal source material. The crucible is stated to be made of graphite.

Patent Reference 2 discloses a method fro fabricating an aluminium nitride crystal using a tungsten crucible with an elongated wall structure.

### Citation List

### Patent Literature

Patent Reference 1: Japanese Unexamined Pat. App. Pub. No. 2006-27988
Patent Reference 2: US2003127044

### Non Patent Literature

Non-Patent Reference 1: Journal of Crystal Growth 34, pp. 263-279 (1976)
Non-Patent Reference 2: Journal of Ccystal Growth 306,00.39-46 (2007)

### Technical Problem

Nevertheless, in growing nitride semiconductor crystal, with the above-cited Non-Patent Reference 1, a carbonous crucible is employed, and with Patent Reference 1, a graphitic crucible is. When the crucibles are heated so as to sublime the source material for the nitride semiconductor crystal, the carbon and the graphite can become sublimed as well. In that case, the sublimed carbon or graphite mixes into the nitride semiconductor that is grown. A consequent problem has been that impurities are mixed into the grown nitride semiconductor crystal.

Accordingly, the present invention affords a nitride semiconductor crystal manufacturing method as set forth in claim 1 that is for manufacturing nitride semiconductor crystal in which the mixing-in of impurities is kept under control, and makes the nitride semiconductor crystals, and apparatuses for manufacturing the nitride semiconductor crystals, available.

### Solution to Problem

With a nitride semiconductor crystal manufacturing method of the present invention, the following steps are carried out. To begin with, a crucible for interiorly carrying source material is prepared. Within the crucible, heating of the source material sublimes the source material, and by the condensing of source-material gases caused, nitride semiconductor crystal is grown. In the crucible preparation step, the crucible is made of a metal whose melting point is higher than that of the source material.

A nitride semiconductor crystal manufacturing apparatus of the present invention as set forth in claim 3 is an apparatus whereby a nitride-semiconductor-containing source material is sublimed and nitride semiconductor crystal is grown by the condensing of the sublimed source-material gases, and is furnished with a crucible and a heating unit. The crucible is where, interiorly, source material is disposed. The heating unit is disposed about the outer periphery of the crucible, and heats the crucible interior. The crucible is made of a metal whose melting point is higher than that of the source material.

In accordance with a nitride semiconductor crystal manufacturing method and manufacturing apparatus, nitride semiconductor crystal is grown inside a crucible made of a metal whose melting point is higher than that of the source material. Subliming of the crucible at the temperatures at which the source material sublimes may thereby be kept under control. Furthermore, the metal's reactivity with the sublimation gases is low. For these reasons, the material constituting the crucible may be kept from mixing into the nitride semiconductor crystal that is grown. Accordingly, nitride semiconductor crystal in which the mixing-in of impurities has been controlled to a minimum can be manufactured.

In the aforedescribed nitride semiconductor crystal manufacturing method, preferably a step of forming a covering component that covers the outer periphery of the crucible is provided in between the crucible preparation step and the growth step.

In the aforedescribed nitride semiconductor crystal manufacturing apparatus, preferably a covering component is arranged in between the crucible and the heating unit.

Impurities may thereby be kept from immixing from the covering-component exterior to the crucible interior. Nitride semiconductor crystal in which the immixing of impurities has been further minimized can therefore be manufactured.

In the aforedescribed nitride semiconductor crystal manufacturing method, preferably the covering component is made of a metal whose melting point is higher than that of the source material.

In the aforedescribed nitride semiconductor crystal manufacturing apparatus, preferably the covering component is made of a metal whose melting point is higher than that of the source material.

Subliming of the covering component may thereby be kept under control, making it possible to manufacture nitride semiconductor crystal in which the mixing-in of impurities is minimized all the more.

The nitride semiconductor crystal manufacturing method described above preferably is further provided with a step of arranging a heating element about the outer periphery of the covering component, and a step of arranging an RF (radio frequency) coil about the outer periphery of the heating element, for heating the heating element.

In the nitride semiconductor crystal manufacturing apparatus described above, preferably the heating unit is an RF coil, and the apparatus is further furnished with a heating element arranged in between the covering component and the heating unit.

The heat that the RF coil generates is not readily absorbed by the metal. Therefore, causing the heat generated through the RF coil to be absorbed by the heating element arranged about the outer periphery of the crucible enables the crucible to be heated by the heat that the heating element has absorbed. The source material can thereby be sublimed. Accordingly, likewise as noted above, nitride semiconductor crystal in which the mixing-in of impurities has been controlled to a minimum can be manufactured.

The nitride semiconductor crystal manufacturing method described above preferably is further provided with a step of arranging about the outer periphery of the heating element a heat insulator consisting of a material that is less porous than the heating element is.

The nitride semiconductor crystal manufacturing apparatus described above preferably is further furnished with a heat insulator, disposed in between the heating element and the RF coil, and consisting of a material that is less porous than the heating element is.

Since a heat insulator consisting of a material that is less porous than the heating element is arranged about the outer periphery of the heating element, the heat that the heating element has absorbed can be kept from escaping to the outer periphery of the heat insulator. The crucible can thereby be heated efficiently. Accordingly, likewise as noted above, nitride semiconductor crystal in which the mixing-in of impurities has been controlled to a minimum can be manufactured.

Nitride semiconductor crystal produced by the method and apparatus of the present invention is manufactured by any of the nitride semiconductor crystal manufacturing methods described above.

In accordance with nitride semiconductor crystal of the present invention, since the crystal is manufactured with sublimation of the crucible being kept under control, nitride semiconductor crystal in which the mixing-in of impurities has been controlled to a minimum can be realized.

The aforedescribed nitride semiconductor crystal preferably has a diameter of at least 10 mm, and has an impurity concentration of not greater than 2 ppm.

The aforedescribed nitride semiconductor crystal is manufactured by sublimation growth, which makes it possible to realize crystals having a large diameter of 10 mm or more. And since it is manufactured with sublimation of the crucible being kept under control, nitride semiconductor crystal of low, 2 ppm or less, impurity concentration can be realized. Accordingly, nitride semiconductor crystal of large surface area and low impurity concentration can be realized.

### Advantageous Effects of Invention

From the foregoing, in accordance with a nitride semiconductor crystal manufacturing method and manufacturing apparatus of the present invention, a crucible made of a metal whose melting point is higher than that of the source material is utilized. Impurities due to sublimation of the crucible may therefore be kept from mixing into the nitride semiconductor crystal that is grown. Accordingly, nitride semiconductor crystal in which the mixing-in of impurities has been controlled to a minimum can be manufactured.

### Brief Description of Drawings

Fig. 1 is a sectional diagram representing, in a simplified form, a nitride semiconductor crystal in a mode of embodying the present invention.
Fig. 2 is a sectional diagram representing, in a simplified form, a nitride semiconductor crystal manufacturing apparatus in a mode of embodying the present invention.
Fig. 3 is a sectional diagram representing, in a simplified form, a crucible and its environs, which the nitride semiconductor crystal manufacturing apparatus in a mode of embodying the present invention comprises.
Fig. 4 is a flowchart setting forth a procedure, in a mode of embodying the present invention, for manufacturing nitride semiconductor crystal.
Fig. 5 is a partially fragmented sectional view illustrating, in a simplified form, a situation in which nitride semiconductor crystal is grown in a mode of embodying the present invention.
Fig. 6 is an enlarged sectional diagram representing, in a simplified form, a nitride semiconductor crystal manufacturing apparatus of a comparative example.
Fig. 7 is a sectional diagram representing, in a simplified form, a different apparatus, in a mode of embodying the present invention, for manufacturing nitride semiconductor crystal.

### Description of Embodiments

Below, a description of modes of embodying the present invention will be made based on the drawings. It should be understood that in the following, identical or corresponding parts in the drawings are labeled with identical reference marks, and their description will not be repeated.

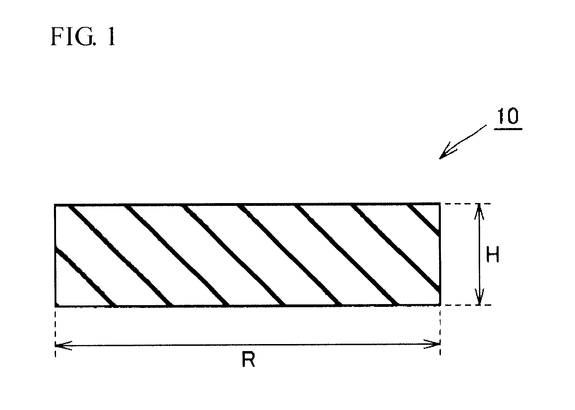

To begin with, referring to Fig. 1, an explanation of a nitride semiconductor crystal 10 in one mode of embodying the present invention will be made. The nitride semiconductor crystal 10 has a diameter *R* of, for example, at least 10 mm and a thickness *H* of, for example, at least 100 µm. The concentration of impurities in the nitride semiconductor crystal 10 is, for example, not greater than 2 ppm. The impurities constituting the impurity concentration include, for example, C (carbon) and Si (silicon). The C concentration in the nitride semiconductor crystal 10 is, for example, not greater than 1 ppm, while the Si concentration is, for example, not greater than 1 ppm.

As long as it is a semiconductor crystal containing nitrogen (N), the nitride semiconductor crystal 10 is not particularly limited; exemplarily it is In_{(1-*x*-*y*)}Al*ₓ*Ga*_{y}*N (0 ≤ *x* ≤ 1, 0 ≤ *y* ≤ 1, 0 ≤ *x* + *y* ≤ 1), and preferably is AlN, GaN (gallium nitride), InN (indium nitride), etc.; more preferably the crystal is AlN.

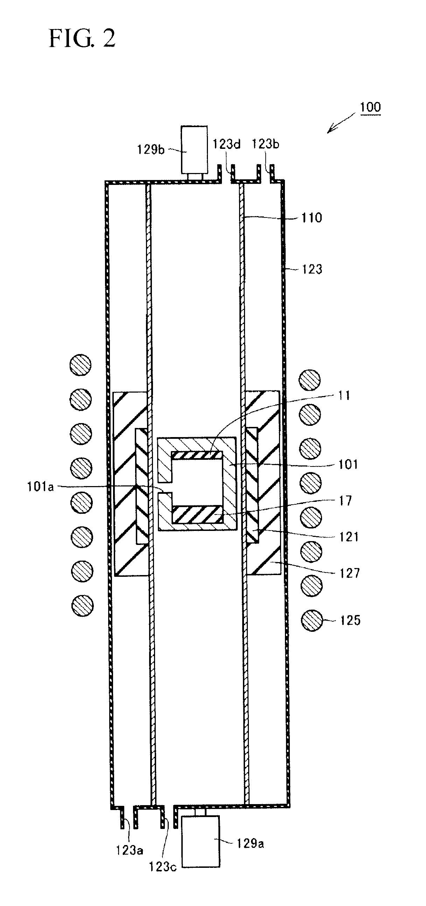

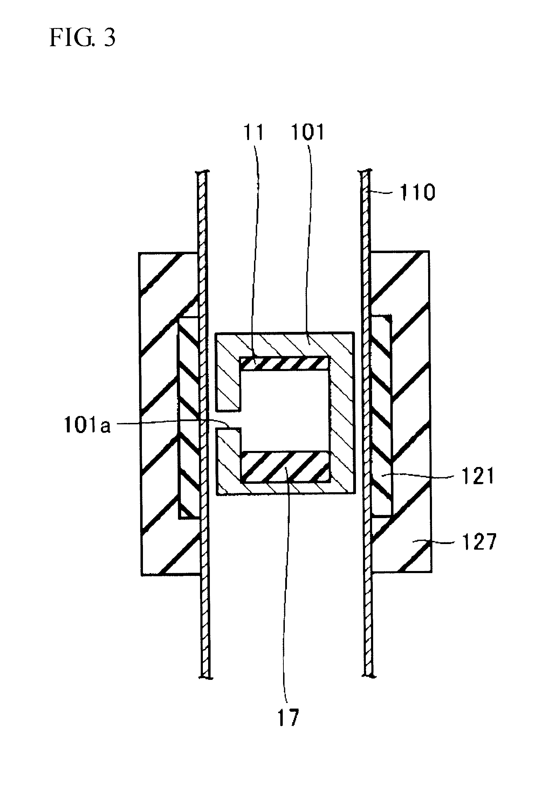

To continue: Referring to Figs. 2 and 3, an explanation of an apparatus 100, in one mode of embodying the present invention, for manufacturing nitride semiconductor crystal 10 will be explained. The manufacturing apparatus 100 is a device for growing nitride semiconductor crystal 10 by subliming a nitride-semiconductor-containing source material to cause the sublimed source-material gases to condense into a crystal.

As indicated in Figs. 2 and 3, the manufacturing apparatus 100 in the present embodying mode principally comprises a crucible 101, a covering sleeve 110 as a covering component, a heating element 121, a heat insulator 127, a reaction vessel 123, and a heating unit 125.

The crucible 101 is where, interiorly, a source material 17 and a base substrate 11 are set into place. The crucible 101 is made of a metal whose melting point is higher than that of the source material 17. Such a metal may be, to cite examples, tantalum (Ta), tungsten (W) or rhenium (Re), as well as their alloys. In other words, the crucible 101 does not contain C atoms. Subliming of the material constituting the crucible 101 at temperatures that sublime the source material may thereby be curtailed. Furthermore, the metals' reactivity with the sublimation gases is low. Still further, such metals are advantageous because their emissivity is high, because their thermal resistance is high, and because they are industrially exploitable. Especially it is preferable that the crucible 101 be Ta, because its reactivity with nitride semiconductors is low, and it excels in thermal resistance at high temperatures. Herein, the aforementioned "melting point" signifies the melting point at 1 atmosphere.

The crucible 101 also has an exhaust port 101*a*. The exhaust port 101*a* exhausts impurities in the crucible 101 interior to the exterior of the crucible 101. Providing the crucible with the exhaust port 101*a* keeps abnormal growth under control, making it possible to grow monocrystalline nitride semiconductor crystal with ease.

Encompassing the crucible 101, the covering sleeve 110 is arranged so as to jacket the crucible 101. In the present embodying mode, the covering sleeve 110 preserves ventilation of the reaction vessel 123 with the exterior through an inlet port 123*c* and an exhaust port 123*d* of the reaction vessel 123, and hermetically closes off the crucible 101 in the regions apart from there. In particular, the covering sleeve 110 is arranged spaced apart from the crucible 101, while other than at the inlet port 123*c* and exhaust port 123*d* the crucible 101 is sealed off by the covering sleeve 110 and the reaction vessel 123. In this way the covering sleeve 110 prevents impurities from invading the crucible 101 from the heating element 121, the heat insulator 127, the reaction vessel 123, etc. on the exterior of the covering sleeve 110.

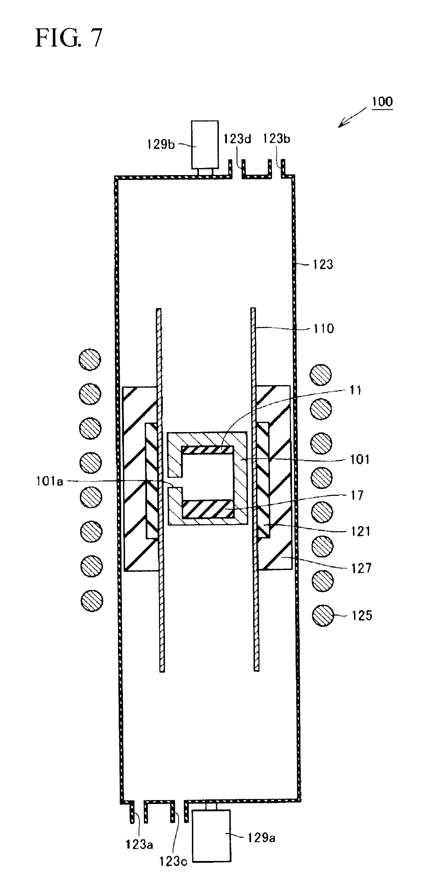

It should be noted that the covering sleeve 110 is not limited to the above-described structure that hermetically shuts off the crucible 101. That is, even if the covering sleeve 110 does not seal off the crucible 101, it will have the effect described above. For example, as illustrated in Fig. 7, the covering sleeve 110 may have openings on the upper and lower sides in the manufacturing apparatus 100. Likewise, the covering sleeve 110 may have an opening on either the upper side or the lower side in the manufacturing apparatus (not illustrated). In such implementations, by flowing gas into the interior of the covering sleeve 110, the same action as that of the above-described hermetically closed structure will operate, so that impurities may be prevented from invading the crucible 101 from the heating element 121, the heat insulator 127, the reaction vessel 123, etc. on the exterior of the covering sleeve 110.

The covering sleeve 110 preferably is made of a metal whose melting point is higher than that of the source material. Such a metal may be, to cite examples, Ta, W or Re, as well as their alloys-likewise as with the material constituting the crucible 101-with it being preferable that the component is made from Ta. The fact that Ta does not readily react with C allows the covering sleeve 110, even in implementations in which the heating element 121 and the heat insulator 127 contain C, to minimize reactions with C having sublimed and mixed in from the heating element 121 and the heat insulator 127. And even in implementations in which the reaction vessel 123 contains Si, the covering sleeve 110 can minimize reactions with Si having sublimed and mixed in from the reaction vessel. The covering sleeve 110 may be of the same material as that of the crucible 101, or it may be of a different material. It should be understood that the covering sleeve 110 may be omitted.

The heating element 121 is disposed about the outer periphery of the covering sleeve 110, and in the present embodying mode is arranged contacting the covering sleeve 110. The heating element 121, a densified body, absorbs heat from the heating unit 125 and heats the interior of the crucible 101. The heating element 121 exemplarily contains C, from the standpoint of excelling in thermal resistance, and for example it consists of graphite. It should be understood that the heating element 121 may be omitted.

The heat insulator 127 is disposed about the outer periphery of the heating element 121, and in the present embodying mode is arranged contacting the heating element 121 in such as way as to cover the entire outer periphery of the heating element 121. The heat insulator 127 is made of a material that is less porous (of lower porosity) than is the heating element 121. The heat insulator 127 keeps the heat that the heating element 121 has absorbed from escaping to the exterior. It will be appreciated that the heat insulator 127 itself does not readily absorb heat from the heating unit 125. The heat insulator 127 exemplarily contains C, from the standpoint of excelling in thermal resistance, and for example consists of carbon felt wrapped into a concentric circular form. It should be understood that the heat insulator 127 may be omitted.

Arranged encompassing the heat insulator 127 is the reaction vessel 123. The manufacturing apparatus 100 has inlet ports 123*a* and 123*c*, formed on one end portion of the reaction vessel 123 (in the present embodying mode, the lower end) and for flowing, for example, a carrier gas such as gaseous nitrogen (N₂) inside the reaction vessel 123, and exhaust ports 123*b* and 123*d*, formed on the other end portion of the reaction vessel 123 (in the present embodying mode, the upper end) and for exhausting the carrier gas to the exterior of the reaction vessel 123. The inlet port 123*a* and the exhaust port 123*b* are disposed outside of the covering sleeve 110 within the reaction vessel 123. The inlet port 123*c* and the exhaust port 123*d* are disposed inside of the covering sleeve 110 within the reaction vessel 123. This means that the inlet port 123*c* flows carrier gas to the crucible 101 disposed inside the reaction vessel 123. And the exhaust port 123*d* exhausts carrier gas, impurities, etc. from the crucible 101 to the exterior of the reaction vessel 123. It should be understood that the reaction vessel 123 may be omitted.

The heating unit 125 is arranged about the outer periphery of the crucible 101, where it heats the interior of the crucible 101. Since the crucible 101 in the present embodying mode is positioned in the midportion of the reaction vessel 123 interior, the heating unit 125 is disposed in the midportion along the outer side of the reaction vessel 123. For the heating unit 125, an RF coil, a resistive heating coil, or the like can for example be utilized. In implementations in which an RF coil is utilized, heating the heating element 121 heats the interior of the crucible 101. In implementations in which a resistive heating coil is utilized, the interior of the crucible 101 is heated directly. For that reason, in a case where a resistive heating coil is utilized as the heating unit 125, the heating element 121 and the heat insulator 127 may be omitted.

In addition, on its lower and upper portions the reaction vessel 123 is provided with pyrometers 129*a* and 129*b* for measuring the temperature of the top side of the crucible 101 (the temperature along the source material 17) and the temperature of the bottom side of it (the temperature along the base substrate 111). It should be understood that the pyrometers 129*a* and 129*b* may be omitted.

It will be appreciated that while the above-described manufacturing apparatus 100 may include various elements apart from those described, for convenience's sake in the description, illustration and explanation of such elements has been omitted.

To continue: An explanation of a method, in the present embodying mode, of manufacturing a nitride semiconductor crystal 10 will be made. In the present embodying mode, the nitride semiconductor crystal 10 is manufactured by sublimation growth utilizing the manufacturing apparatus 100 illustrated in Figs. 2 and 3.

At first, with the source material 17 being set into its interior, as indicated in Figs. 2 and 3, the crucible 101, made of a metal whose melting point is higher than that of the source material 17, is prepared. Next, the covering sleeve 110 is formed as the covering component about the outer periphery of the crucible 101. It is preferable that the covering sleeve 110 be made of a metal whose melting point is higher than that of the source material 17. The heating element 121 is then arranged about the outer periphery of the covering sleeve 110. Next, the heat insulator 127, constituted from a material that is less porous than is the heating element 121, is arranged about the outer periphery of the heating element 121. The reaction vessel 123 is then arranged about the outer periphery of the heat insulator 127. Thereafter the heating unit 125 is set into place encompassing the reaction vessel 123. In sum, referring to Fig. 4, the manufacturing apparatus 100 depicted in Figs. 2 and 3 is prepared (Step S1) in the present embodying mode.

Next, as indicated in Figs. 2 through 4, the base substrate 11 is set into place (Step S2). While the base substrate is not particularly limited, preferably it is a substrate having the identical atomic ratio as that of the nitride semiconductor crystal that is grown. The base substrate 11 is placed in the upper portion of the crucible 101. It should be understood that Step S2 may be omitted. In that case, the nitride semiconductor crystal is grown by spontaneous nucleation.

Next, the source material 17 is set into place (Step S3). While the source material 17 is not particularly limited, preferably its level of purity is high. For example, in an instance in which the nitride semiconductor crystal that is grown is AlN crystal, for the source material 17 a sintered AlN source material preferably is employed. In that case, sintering additives will not be included in the source material 17. The source material 17 is placed in the lower portion of the crucible 101 so that it and the base substrate 11 face each other.

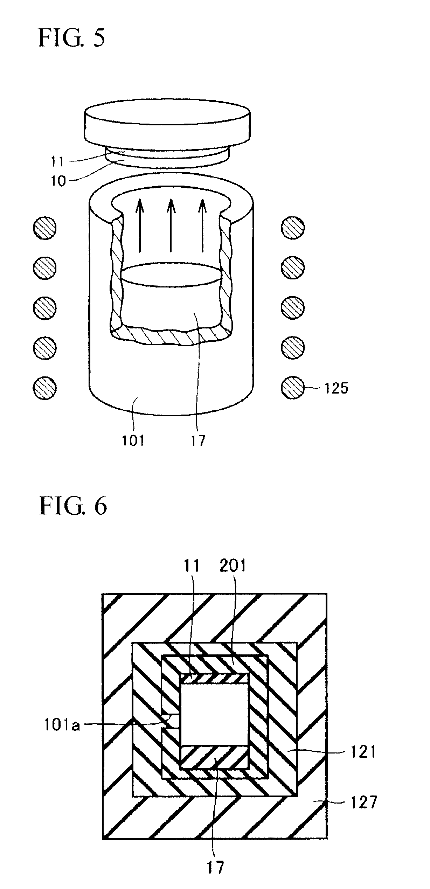

Next, as indicated in Figs. 4 and 5, the source material 17 is heated, thereby subliming the material and, in the region inside the crucible 101 opposing the source material 17, condensing the material into a crystal, which grows nitride semiconductor crystal 10 (Step S4). In the present embodying mode, the nitride semiconductor crystal 10 is grown by the sublimed source-material gases being caused to condense onto the base substrate.

In this Step S4, in implementations in which AlN crystal is grown as the nitride semiconductor crystal 10, the heating unit 125 is controlled, for example, so as to have the temperature along the base substrate 11 be 1400°C to 1800°C, and so that the temperature along the source material 17 will be 1850°C to 2150°C. In implementations in which GaN crystal is grown as the nitride semiconductor crystal 10, the heating unit 125 is controlled, for example, so as to have the temperature along the base substrate 11 be 1450°C to 1550°C, and so that the temperature along the source material 17 will be 1600°C to 1700°C.

For this Step S4, the nitride semiconductor crystal 10 preferably is grown with the covering sleeve 110 arranged about the outer periphery of the crucible 101. In sublimation growth, since the nitride semiconductor crystal 10 is grown at high temperatures such as noted above, the materials constituting the heating element 121, the heat insulator 127 and the reaction vessel 123, located externally of the covering sleeve 110, are liable to sublime. Arranging the covering sleeve 110, however, keeps sublimed impurities from mixing into the interior of the crucible 101.

In implementations in which nitride semiconductor crystal 10 is grown with the covering sleeve 110 arranged about the outer periphery of the crucible 101, the carrier gas that is flowed along the inner periphery of the covering sleeve 110 (gas that is flowed from the inlet port 123*c* and is exhausted through the exhaust port 123*d*), and the carrier gas that is flowed along the outer periphery of the covering sleeve 110 (gas that is flowed from the inlet port 123*a* and is exhausted through the exhaust port 123*b*) may be the same, or they may be different. It is preferable that gaseous nitrogen be flowed along the inner periphery of the covering sleeve 110 within the reaction vessel 123, and that a gas other than gaseous nitrogen be flowed along the outer periphery of the covering sleeve 110 within the reaction vessel 123. As the gas flowed along the outer periphery of the covering sleeve 110, preferably an inert gas such as gaseous argon (Ar) is flowed. In that case, the generation of hydrogen cyanide (HCN) gas may be kept under control, therefore making hazardous-waste removal equipment unnecessary.

It should be noted that in implementations in which nitride semiconductor crystal 10 is grown employing a base substrate 11, preferably a step of stripping away the base substrate 11 is carried out.

By means of foregoing Steps S1 through S4, nitride semiconductor crystal 10 represented in Fig. 1 can be manufactured. In the present embodying mode, nitride semiconductor crystal 10 is manufactured under circumstances in which subliming of the material constituting the crucible 101 is kept under control. Mixing of impurities into the nitride semiconductor crystal 10 that is manufactured may therefore be kept under control. In particular, by growing the nitride semiconductor crystal 10 with the covering sleeve 110 0 arranged about the outer periphery of the crucible 101, impurities from the subliming of the materials constituting the components situated about the outer periphery of the crucible 101 may be kept from mixing into the nitride semiconductor crystal 10 that is manufactured. And the fact that the nitride semiconductor crystal 10 is produced by sublimation growth makes possible the manufacture of nitride semiconductor crystal 10 of large surface area. Nitride semiconductor crystal 10 for example having a diameter of at least 10 mm, and having an impurity concentration of not greater than 2 ppm can be manufactured as a result.

Accordingly, nitride semiconductor crystal 10 of low impurity concentration, manufactured by a nitride semiconductor crystal manufacturing method and a manufacturing apparatus 100 of the present embodying mode can be ideally utilized as substrates for devices including, for example: optical devices such as light-emitting diodes and laser diodes; semiconductor electronic devices such as rectifiers, bipolar transistors, field-effect transistors, and high electron mobility transistors (HEMTs); field emitters; semiconductor sensors such as temperature sensors, pressure sensors, radiation sensors, and visible-ultraviolet photodetectors; and surface acoustic wave devices (SAW devices), vibrators, resonators, oscillators, microelectromechanical system (MEMS) parts, and piezoelectric actuators. In particular, since nitride semiconductor crystal 10 having few defects, low dislocation density, and superior optical transmission characteristics may be manufactured, it is advantageously utilized in light-emitting semiconductor devices.

### Embodiment 1

In the present embodiment, the effectiveness of manufacturing nitride semiconductor crystal utilizing a crucible made of a metal whose melting point is higher than that of the source material was investigated.

### Present Invention Example 1

Nitride semiconductor crystal 10 of Present Invention Example 1 was manufactured utilizing the manufacturing apparatus 100 represented in Figs. 1 and 2, in accordance with the embodying mode explained above.

Specifically, to begin with, the manufacturing apparatus 100 as furnished with a crucible 101 made of Ta was prepared (Step S1). Here, the heating element 121 consisted of graphite, while the heat insulator 127 consisted of carbon felt. Also, for the reaction vessel 123 a quartz tube was used. And the covering sleeve 110 consisted of Ta.

Next, AlN as the source material 17 was set into place in the interior of the crucible 101 (Step S3). The melting point of Ta, the material constituting the crucible 101, is 2990°C while the melting point of AIN, the source material, is 2200°C, wherein the melting point of the crucible 101 was higher than the melting point of the source material 17.

Next, an AlN substrate as the base substrate 11 was arranged in the interior of the crucible 101 so as to oppose the source material 17 (Step S2).

Next, gaseous N₂ as a carrier gas was flowed, and under a N₂ atmosphere, with the growth temperature being 2000°C, AlN crystal as the nitride semiconductor crystal 10 was grown (Step S4).

After being cooled, the AlN crystal of Present Invention Example 1 was taken out from the manufacturing apparatus 100. The result was that Present Invention Example 1 AlN crystal having a thickness of 1 mm had been formed onto the base substrate 11.

### Comparative Example 1

Nitride semiconductor crystal of Comparative Example 1 was manufactured in a way that was basically the same as that of Present Invention Example 1, but that differed in that the material constituting the crucible 101 was carbon, and in that a covering sleeve 110 was not installed.

Specifically, AlN crystal of Comparative Example 1 was manufactured employing the manufacturing apparatus depicted in Fig. 6. That is, the manufacturing apparatus employed in Comparative Example 1 was furnished with a carbonous crucible 201, a heating element 121 covering the outer periphery of the crucible 201, and a heat insulator 127 covering the outer periphery of the heating element 121. Comparative Example 1 AlN crystal having a thickness of 1 mm was thereby produced on the base substrate 11.

### Comparative Example 2

Nitride semiconductor crystal of Comparative Example 2 was manufactured in a way that was basically the same as that of Present Invention Example 1, but that differed in that the material constituting the crucible 101 was TaC (tantalum carbide), and in that a covering sleeve 110 was not installed.

Specifically, in the manufacturing apparatus depicted in Fig. 6, employed in Comparative Example 1, a crucible consisting of TaC, in which the material of the crucible 101 was Ta : C = 1 : 1, was employed. Comparative Example 2 AlN crystal having a thickness of 1 mm was thereby produced on the base substrate 11.

### Measurement Method

SIMS was employed to measure the Si concentration, C concentration and O concentration as the impurity concentration in the AlN crystal of Present Invention Example 1, Comparative Example 1 and Comparative Example 2. The results are set forth in Table I below.

**Table I.**

| | **C conc.** | **Si conc.** | **O conc.** | **Impurity conc.** |
|---|---|---|---|---|
| **Pres. Invent. Ex. 1** | 1 ppm or less | ppm or less | 0 ppm | 2 ppm or less |
| **Comp. Ex. 1** | 10 ppm | 10 ppm | 0 ppm | 20 ppm |
| **Comp. Ex. 2** | 5 ppm | 5 ppm | 0 ppm | 10 ppm |

### Measurement Results

As indicated in Table I, in the AlN crystal of Present Invention Example 1, which was manufactured utilizing a crucible 101 made from a metal that did not contain C and whose melting point was higher than that of the source material 17, the C concentration and Si concentration were each not greater than 1 ppm, while the impurity concentration was, at not greater than 2 ppm, extraordinarily low.

On the other hand, in the AlN crystal of Comparative Example 1, which was manufactured employing a crucible made from carbon, the C concentration and Si concentration were 10 ppm, and the impurity concentration, at 20 ppm, was extraordinarily high.

In the AlN crystal of Comparative Example 2, which was manufactured employing a crucible made from TaC, although the C concentration, Si concentration, and impurity concentration were lower than those of the AlN crystal of Comparative Example 1, they were all higher than the impurity concentration of the AlN crystal of Present Invention Example 1.

As far as the carbon is concerned, the material constituting the crucible 201, the heating element 121, and the heat insulator 127 sublimed and, through the exhaust port 101*a* in the crucible 101, mixed into the AlN crystal. As far as the silicon is concerned, the material constituting the reaction vessel 123 sublimed and, through the exhaust port 101 a in the crucible 101, mixed into the AlN crystal. Consequently, from the results with the carbon concentration, it was understood that by means of the material constituting the crucible 101, the C concentration could be reduced. From the results with the silicon concentration, it was understood that by installing a covering sleeve 110, the Si i concentration could be reduced.

Therein, the inventors gained the insight that if the crucible 101 interior is completely sealed shut without providing the crucible 101 with the exhaust port 101*a*, the crystal will grow abnormally, without growing into single crystal. Therefore, it is necessary that an exhaust port 101*a* be formed in the crucible 101. Accordingly, it was understood that by the material constituting the crucible 101 being different from that of the comparative examples, the impurity concentration could be lowered in AlN crystal that does not grow abnormally.

From the foregoing it could be confirmed that according to the present embodiment, utilizing a crucible 101 made of a metal whose melting point is higher than that of the source material to manufacture AlN crystal as nitride semiconductor crystal 10 made it possible to reduce the concentration of impurities contained in the manufactured AlN crystal.

In the present embodiment, an explanation was made with AlN crystal being given as an example of nitride semiconductor crystal 10. Nevertheless, with regard to nitride semiconductor crystal 10 other than AlN crystal, by rendering the material constituting the crucible 101 in the same way, the crucible 101 may be kept from subliming at the temperatures at which the source material 17 sublimes. Furthermore, the metal's reactivity with the sublimation gases is low. Therefore, also with regard to nitride semiconductor crystal 10 other than AIN crystal, mixing of the material constituting the crucible 101 into the nitride semiconductor crystal that is grown may likewise be kept under control. Accordingly, in the same way as with Embodiment 1, nitride semiconductor crystal 10 in which immixing of impurities has been minimized can be manufactured.

### Embodiment 2

In the present embodiment the effectiveness, in a manufacturing apparatus furnished with a covering component, of flowing a gas that does not contain nitrogen along the outer periphery of the covering component was investigated.

### Samples 1 through 3

With Samples 1-3, AlN crystal was manufactured basically utilizing the manufacturing apparatus 100 of Present Invention Example 1, but differed in that as the carrier gas, gaseous N₂ was flowed along the inner periphery of the covering sleeve 110 0 within the reaction vessel 123, and gaseous helium (He), gaseous neon (Ne) and gaseous Ar were respectively flowed along the outer periphery of the covering sleeve 110 within the reaction vessel 123.

In the manufacture of each of the AIN crystals in which each of the carrier gases were flowed, the hydrogen-cyanide gas concentration inside the reaction vessel 123 was measured with a hydrogen-cyanide gas sensor. In turn, in the manufacture of AlN crystal in Present Invention Example 1, in which gaseous N₂ was flowed along both the outer periphery and along the inner periphery of the covering sleeve 110, the hydrogen-cyanide gas concentration inside the reaction vessel 123 was measured in the same manner. The results are set forth in Table II.

**Table II.**

| | Gas on covering-sleeve outer periphery | | | |
|---|---|---|---|---|
| | N₂ (Pres. Invent. Ex. 1) | He (Sample 1) | Ne (Sample 2) | Ar (Sample 3) |
| Hydrogen-cyanide gas conc. | 30 ppm | Less than 1 ppm | Less than 1 ppm | Less than 1 ppm |

As indicated in Table II, in the samples in which an inert gas other than gaeous nitrogen was flowed along the outer periphery of the covering component, the concentration of hydrogen cyanide gas generated in the manufacture of AlN crystal proved to be less than 1 ppm; hydrogen cyanide gas was scarcely generated. On the other hand, in the sample in which nitrogen was flowed along the outer periphery of the covering component, 30 ppm hydrogen cyanide gas was detected. Consequently, it was understood that flowing an inert gas other than gaseous nitrogen along the outer periphery of the covering component allowed hazardous-waste removal equipment for clearing away any hydrogen-cyanide gas hazard to be omitted.

From the foregoing, it could be confirmed that according to the present embodiment, in a manufacturing apparatus furnished with a covering component, flowing a gas other than gaseous nitrogen along the outer periphery of the covering component allowed the manufacturing apparatus to be simplified.

While a description of embodying modes and embodiment examples of the present invention has been undertaken in the foregoing manner, combining the features of each of the embodying modes and embodiment examples to suit is contemplated from the outset. Furthermore, the presently disclosed embodying modes and embodiment examples should in all respects be considered to be illustrative and not limiting. The scope of the present invention is set forth not by the foregoing embodying modes and embodiment examples but by the scope of the claims, and is intended to include meanings equivalent to the scope of the claims and all modifications within the scope.

**10**: nitride semiconductor crystal; **11**: base substrate; **17:** source material; **100:** manufacturing apparatus; **101**: crucible; **101*a***: exhaust port; **110:** covering sleeve; **121:** heating element; **123**: reaction vessel; **123*a***, **123*c***: inlet ports; **123*****b**,* **123*d***: exhaust ports; **125**: heating unit; **127**: heat insulator; **129*a***, **129*b***: pyrometers; ***H*:** thickness; ***R***: diameter

## Claims

1. A method of manufacturing a In_{(1-*x*-*y*)}Al*ₓ*Ga*_{y}*N (0 ≤ *x* ≤ 1, 0 ≤ *y* ≤ 1, 0 ≤ *x* + *y* ≤ 1) crystal (10), comprising:
a step of preparing a crucible (101) for interiorly carrying source material;
a step of, within the crucible, subliming the source material (17) by heating the source material, to cause source-material gases to condense and thereby grow nitride semiconductor crystal; wherein
in said preparation step, a crucible (101) made from a metal whose melting point is higher than that of the source material (17) is prepared;
in between said crucible preparation step and said growth step, a step of forming a covering component (110) that covers the outer periphery of the crucible (101);
wherein the covering component (110) is made of a metal whose melting point is higher than that of the source material (17);
a step of arranging a heating element (121) about the outer periphery of the covering component (110); and
a step of arranging an RF coil about the outer periphery of the heating element (121), for heating the heating element (121),
wherein the crucible (101) has an exhaust port (101 a).

2. The In_{(1-*x*-*y*)}Al*ₓ*Ga*_{y}*N (0 ≤ *x* ≤ 1, 0 ≤ *y* ≤ 1, 0 ≤ x + *y* ≤ 1) crystal (10) manufacturing method set forth in claim 1, further comprising a step of arranging about the outer periphery of the heating element (121) a heat insulator (127) consisting of a material that is less porous than the heating element (121) is.

3. An apparatus (100) for manufacturing a In_{(1-*x*-*y*)}Al*ₓ*Ga*_{y}*N (0 ≤ *x* ≤ 1, 0 ≤ *y* ≤ 1, 0 ≤ *x* + *y* ≤ 1) crystal (10), whereby a nitride-semiconductor-containing source material (17) is sublimed and nitride semiconductor crystal (10) is grown by the condensing of the sublimed source-material gases, the apparatus comprising:
a crucible (101) for interiorly carrying source material (17);
a heating unit (125) disposed about the outer periphery of the crucible (101) for heating the crucible (101) interior; wherein
the crucible (101) has an exhaust port (101a) and is made of a metal whose melting point is higher than that of the source material (17);
a covering component (110) arranged in between said crucible (101) and said heating unit (125);
wherein said covering component (110) is made of a metal whose melting point is higher than that of the source material (17);
said heating unit (125) being an RF coil;
therein further comprising a heating element (121) arranged in between said covering component (110) and said heating unit (125).

4. The In_{(1-*x*-*y*)}Al*ₓ*Ga*_{y}*N (0 ≤ *x* ≤ 1, 0 ≤ *y* ≤ 1, 0 ≤ *x* + *y* ≤ 1) crystal (10) manufacturing apparatus (100) set forth in claim 5, further comprising a heat insulator (127), disposed in between said heating element (121) and said RF coil, and consisting of a material that is less porous than said heating element is.

## Patentansprüche

1. Verfahren zur Herstellung eines In_{(1-x-y)}AlₓGa_{y}N (0 ≤ x ≤ 1, 0 ≤ y ≤ 1, 0 ≤ x + y ≤ 1) Kristalls (10), umfassend:
einen Schritt des Herstellens eines Schmelztiegels (101), um im Innenraum ein Ausgangsmaterial zu halten;
einen Schritt des Sublimierens des Quellenmaterials (17) im Schmelztiegel durch Erhitzen des Ausgangsmaterials, um eine Kondensation von Ausgangsmaterialgasen zu bewirken und dadurch einen Nitrid-Halbleiterkristall zu wachsen;
wobei in dem Herstellungsschritt, ein Schmelztiegel (101) aus einem Metall, dessen Schmelzpunkt höher als der des Ausgangsmaterials (17) ist, hergestellt wird;
zwischen dem Schmelztiegelherstellungsschritt und dem Wachstumsschritt, einen Schritt des Bildens eines Abdeckelements (110), der den Außenumfang des Schmelztiegels (101) bedeckt;
wobei das Abdeckelement (110) aus einem Metall gebildet ist, dessen Schmelzpunkt höher als der des Ausgangsmaterials (17) ist;
einen Schritt des Anordnens eines Heizelements (121) um den Außenumfang des Abdeckelements (110); und
einen Schritt des Anordnens einer HF-Spule um den Außenumfang des Heizelements (121) zum Heizen des Heizelements (121),
wobei der Schmelztiegel (101) eine Auslassöffnung (101a) aufweist.

2. Verfahren zur Herstellung eines In_{(1-x-y)}AlₓGa_{y}N (0 ≤ x ≤ 1, 0 ≤ y ≤ 1, 0 ≤ x + y ≤ 1) Kristalls (10) gemäß Anspruch 1, das ferner einen Schritt des Anordnens eines Wärmeisolators (127) aus einem Material, das weniger porös als das Heizelement (121) ist, um den Außenumfang des Heizelements (121) aufweist.

3. Vorrichtung (100) zur Herstellung eines In_{(1-x-y)}AlₓGa_{y}N (0 ≤ x ≤ 1, 0 ≤ y ≤ 1, 0 ≤ x + y ≤ 1) Kristalls (10), wobei ein Nitrid-Halbleiter enthaltendes Ausgangsmaterial (17) sublimiert wird, und der Nitrid-Halbleiterkristall (10) mittels Kondensieren der sublimierten Ausgangsmaterialgase aufgewachsen wird, wobei die Vorrichtung umfasst:
einen Schmelztiegel (101), um im Innenraum ein Ausgangsmaterial (17) zu halten;
eine Heizeinheit (125), die um den Außenumfang des Schmelztiegels (101) zum Erhitzen des Innenraums des Schmelztiegels (101) angeordnet ist; wobei
der Schmelztiegel (101) eine Auslassöffnung (101a) aufweist und aus einem Metall, dessen Schmelzpunkt höher als der des Ausgangsmaterials (17) ist, gebildet ist;
ein Abdeckelement (110), das zwischen dem Schmelztiegel (101) und der Heizeinheit (125) angeordnet ist;
wobei das Abdeckelement (110) aus einem Metall gebildet ist, dessen Schmelzpunkt höher als der des Ausgangsmaterials (17) ist;
wobei die Heizeinheit (125) eine HF-Spule umfasst;
wobei darin ferner ein Heizelement (121) zwischen dem Abdeckelement (110) und der Heizeinheit (125) angeordnet ist.

4. Vorrichtung (100) zur Herstellung eines In_{(1-x-y)}AlₓGa_{y}N (0 ≤ x ≤ 1, 0 ≤ y ≤ 1, 0 ≤ x + y ≤ 1) Kristalls (10) nach Anspruch 5, die ferner einen Wärmeisolator (127) umfasst, der zwischen dem Heizelement (121) und der HF-Spule angeordnet und aus einem Material gebildet ist, das weniger porös als das Heizelement ist.

## Revendications

1. Procédé de fabrication d'un cristal In_{(1-*x*-*y*)}Al*ₓ*Ga*_{y}*N (0 ≤ *x* ≤ 1, 0 ≤ *y* ≤ 1, 0 ≤ *x* + *y* ≤ 1) (10), comprenant :
une étape de préparation d'un creuset (101) pour y transporter à l'intérieur un matériau source ;
une étape de sublimation du matériau source (17) dans le creuset en chauffant le matériau source, pour provoquer la condensation de gaz du matériau source et faire croître ainsi un cristal semi-conducteur à nitrure ; dans lequel
lors de ladite étape de préparation, un creuset (101) constitué d'un métal dont le point de fusion est supérieur à celui du matériau source (17) est préparé ;
entre ladite étape de préparation du creuset et ladite étape de croissance, une étape de formation d'un composant de recouvrement (110) qui recouvre la périphérie externe du creuset (101) ;
dans lequel le composant de recouvrement (110) est constitué d'un métal dont le point de fusion est supérieur à celui du matériau source (17) ;
une étape d'agencement de l'élément de chauffe (121) autour de la périphérie externe du composant de recouvrement (110) ; et
une étape d'agencement d'une bobine de radiofréquence autour de la périphérie externe de l'élément de chauffe (121) pour chauffer l'élément de chauffe (121),
dans lequel le creuset (101) comporte un orifice de sortie (101a).

2. Procédé de fabrication d'un cristal In_{(1-*x*-*y*)}Al*ₓ*Ga*_{y}*N (0 ≤ *x* ≤ 1, 0 ≤ *y* ≤ 1, 0 ≤ *x* + *y* ≤ 1) (10) selon la revendication 1, comprenant en outre une étape d'agencement, autour de la périphérie externe de l'élément de chauffe (121), d'un isolant thermique (127) constitué d'un matériau moins poreux que l'élément de chauffe (121).

3. Appareil (100) de fabrication d'un cristal In_{(1-*x*-*y*)}Al*ₓ*Ga*_{y}*N (0 ≤ *x* ≤ 1, 0 ≤ *y* ≤ 1, 0 ≤ *x* + *y* ≤ 1) (10), dans lequel un matériau source (17) contenant un semi-conducteur à nitrure est sublimé et un cristal semi-conducteur à nitrure (10) croît par condensation des gaz de matériau source sublimé, l'appareil comprenant :
un creuset (101) pour y transporter à l'intérieur un matériau source (17) ;
une unité de chauffe (125) agencée autour de la périphérie externe du creuset (101) pour chauffer l'intérieur du creuset (101) ; dans lequel
le creuset (101) comporte un orifice de sortie (101a) et est constitué d'un métal dont le point de fusion est supérieur à celui du matériau source (17) ;
un composant de recouvrement (110) agencé entre ledit creuset (101) et ladite unité de chauffe (125) ;
dans lequel ledit composant de recouvrement (110) est constitué d'un métal dont le point de fusion est supérieur à celui du matériau source (17) ;
ladite unité de chauffe (125) étant une bobine de radiofréquence ;
comprenant en outre à l'intérieur un élément de chauffe (121) agencé entre ledit composant de recouvrement (110) et ladite unité de chauffe (125).

4. Appareil de fabrication (100) d'un cristal In_{(1-*x*-*y*)}Al*ₓ*Ga*_{y}*N (0 ≤ x ≤ 1, 0 ≤ y ≤ 1, 0 ≤ x + y ≤ 1) (10) selon la revendication 5, comprenant en outre un isolant thermique (127) agencé entre ledit élément de chauffe (121) et ladite bobine de radiofréquence, et consistant en un matériau qui est moins poreux que ledit élément de chauffe.
